# EUROPEAN PATENT APPLICATION

(11) **EP 1 811 828 A1**
(43) Date of publication of application: **25.07.2007**
(21) Application number: 06100686.2
(22) Date of filing: 20.01.2006
(51) Int. Cl.: H05K 13/04, H05K 13/08, H01L 21/67, H01L 21/68

(54) **Micromechanical placement system, and corresponding device**

(71) Applicant: MA3 Solutions BV, 5612 AB Eindhoven (NL)
(72) Inventor: Blok, Herman, B-2470 Retie (NL); Eisenberg, Martin, 5685 BG Best (NL); Koppelmans, Hajo, 5685 BJ Best (NL); Korten, Ralf, 5981 DP Panningen (NL); Peters, Hubertus, 5931 LC Tegelen (NL); Smetsers, Antonius, 5688 TS Oirschot (NL)
(74) Representative: Mulder, Cornelis A.M.

(57) **Abstract**

The invention relates to a placement system in a micromechanical assembly device, to a micromechanical assembly device and to a placement method. The placement system constitutes of a first support member (112) a second support member (116) and at least three substantially identical resilient connectors (120). The first support member being connected to the micromechanical assembly device and the second support member being connected to a module (102). Each of the resilient connectors comprising a longitudinal axis (110). The longitudinal axis of each of the resilient connectors being substantially parallel to each other and defining an angle (α) with regard to a central axis (110) arranged substantially perpendicular to the reference plane (106).

The effect of the measures according to the invention is that the angle between the longitudinal axis of each one of the resilient connectors and the central axis enables the module to be pushed against the datum element via a well-defined force which is substantially defined by the angle.

## Description

### FIELD OF THE INVENTION:

The invention relates to a placement system in a micromechanical assembly device.

The invention further relates to a micromechanical assembly device and a placement method.

### BACKGROUND OF THE INVENTION:

Precise and accurate integration & packaging of components relative to one-another within a 3D environment becomes more and more a functional requirement in the assembly process of micro-devices. Improved control with respect to translational and rotational alignment is generally required. Integrated laser scanning devices and vision-based systems are often employed to gain control of micromechanical assembly processes.

A drawback of the known placement systems is that miniaturization requires improved placement accuracy.

### SUMMARY OF THE INVENTION:

It is an object of the invention to provide a placement system having improved placement accuracy.

According to a first aspect of the invention the object is achieved with a placement system in a micromechanical positioning device for positioning a module with respect to a datum element defining a reference position in a reference plane for the module, the placement system comprising: a central axis substantially perpendicular to the reference plane, a first support member including a first imaginary plane substantially parallel to the reference plane, the first support member arranged for connecting to the micromechanical positioning device, a second support member including a second imaginary plane substantially parallel to the reference plane, the second support member arranged for connecting to the module, at least three substantially identical resilient connectors arranged for resiliently connecting the first support member at the first imaginary plane to the second support member at the second imaginary plane, each resilient connector having a longitudinal axis, the longitudinal axis of each resilient connector being substantially parallel to each other and defining an angle with regard to the central axis.

The effect of the measures according to the invention is that the angle between the longitudinal axis of each one of the resilient connectors and the central axis enables the module to be pushed against the datum element via a well-defined force which is substantially defined by the angle. When the module is pushed against the datum element, the second support member will move with respect to the first support member. The resilient connectors are substantially identical, especially in their longitudinal dimensions. The chosen construction together with the use of substantially identical resilient connectors ensures that the first imaginary plane of the first member remains substantially parallel to the second imaginary plane of the second member, thus substantially securing the orientation of the module with respect to the reference plane.

An additional benefit of the claimed subject matter is that the resilient connectors decouple vibrations, for example, resulting from the micromechanical positioning device to the module. The decoupling of the vibrations increases the accuracy in positioning the module with respect to the datum element, thus increasing the accuracy of the micromechanical positioning device. A further benefit of the decoupling of the vibrations is that the cost of the micromechanical positioning device can be reduced, because, for example, expensive air bearings to create a substantially vibration-less environment can be omitted.

In an embodiment of the placement system, the resilient connectors are resilient in a direction parallel to the longitudinal axis and resilient in the direction perpendicular to the longitudinal axis. However, a longitudinal spring constant of the resilient connector in the direction of the longitudinal axis is larger compared to a tangential spring constant of the resilient connector in the direction perpendicular to the longitudinal axis. Due to the difference between the longitudinal spring constant and the tangential spring constant, only a relative small well-defined force displaces the second support member with respect to the first support member while substantially maintaining the second imaginary plane parallel to the first imaginary plane. Furthermore, the longitudinal spring constant of the different resilient connectors may be different. The benefit of this embodiment is that when the placement system is used for placing the module in a production process, a variation of the placement-force, being the force with which the module is placed at a location by the placement system, can be applied across the second support member using resilient connectors having different longitudinal spring constants.

In an embodiment of the placement system, first depressions are provided in the first support member facing the second support member and second depressions are provided in the second support member facing the first support member, said first and second depressions accommodating end portions of the respective resilient connectors, each one of the first and second depressions having a depression central axis substantially parallel to the longitudinal axis of each of the resilient connectors. A benefit of this embodiment is that the first and second depressions enable a secure positioning of the resilient connectors at the angle. Furthermore, the first and second depressions enable all resilient connectors to be secured at the first and second imaginary plane of the first and second support member which ensures that the second support member will remain substantially parallel to the first support member when the well-defined force is applied to the second support member in a direction substantially parallel to the reference plane.

In an embodiment of the placement system, the placement system comprises four substantially identical resilient connectors. A benefit of this embodiment
is that the use of four substantially identical resilient connectors increases a rotational stability, preventing the rotation of the second support member with respect to the first support member around the central axis.

In an embodiment of the placement system, the angle is smaller than 45 degrees, and preferably between 1 and 10 degrees. A benefit of this embodiment is that the force via which the module is fixed against the datum element is well-defined and controlled through the angle.

In an embodiment of the placement system, the angle between the longitudinal axis and the central axis comprises a first angle component in a first direction parallel to the reference plane and comprises a second angle component in a second direction parallel to the reference plane and perpendicular to the first direction. A benefit of this embodiment is that it enables the module to be pushed against the datum element and an additional datum element via a well-defined force, obtaining a fixation of the module in two dimensions. The datum element and the additional datum element together define a reference point in two dimensions in the reference plane.

In an embodiment of the placement system, the module comprises a micro-gripper, a dispensing device, a micro-torch, a mirror, or a laser device.

According to a second aspect of the invention the object is achieved with a micromechanical positioning device comprising a robot arm comprising the placement system of one of the preceding claims, and comprising the datum element defining a reference position in the reference plane, the micromechanical positioning device further comprising a translation means for either translating the module with respect to a further module, or for translating the further module with respect to the module for aligning the module and the further module with respect to each other.

In an embodiment of the micromechanical positioning device, the micromechanical positioning device further comprising a further datum element, the datum element and the further datum element defining a reference line coinciding with the reference position, wherein the translation means, when translating, either translates the module with respect to the further module, the module sliding along the datum element and the further datum element, or translates the further module with respect to the module, the further module sliding along the datum element and the further datum element. A benefit of this embodiment is that the translation of the translation table enables an alignment between the further module and the module while the module is substantially fixed in one dimension at the reference position. The well-defined force which secures the module against the datum and/or the further datum should be chosen such that the sliding of the module does not damage the module or creates dust particles.

In an embodiment of the micromechanical positioning device, the micromechanical positioning device further comprises a fixation datum element for either fixing a predetermined position of the module when the further module is translated or for fixing a predetermined position of the further module when the module is translated. Preferably the fixation datum fixes the predetermined position of the module or the further module in a direction parallel to the reference line. The benefit of this embodiment is that a position of one of the module or the further module is fixed while the other of the module or the further module is translated to align the module with respect to the further module.

In an embodiment of the micromechanical positioning device, the micromechanical positioning device comprises at least three resilient support pins for supporting the further module and comprises an actuator pin for fixing a reference position of the further module against the datum element, or against the datum element and the fixation datum element, the resilience of the at least three resilient support pins enabling a displacement of the further module with respect to the reference plane while omitting a need for sliding the further module over the at least three resilient support pins. A benefit of this embodiment is that an initial placement of the further module in the micromechanical positioning device can be corrected by displacing the further module with respect to the reference plane to obtain a good contact of the further module with the datum elements. The resilience of the three resilient support pins prevent sliding of the further module over the resilient support pins, thus avoiding that the further module is scratched and/or damaged.

According to a third aspect of the invention the object is achieved with a placement method for placing the further module in the micromechanical positioning device as claimed in claim, the placement method comprising a step of: placing the further module on the at least three resilient support pins, applying a first force on the further module in a direction substantially perpendicular to the reference plane pressing the further module against the at least three resilient support pins, the first force being chosen to allow the further module to be displaced with respect to the reference plane while omitting the need for sliding the further module over the at least three resilient support pins, activating the actuator pin for positioning the further module against the datum element, or against the datum element and the fixation datum element, replacing the first force by a second force on the further module, the second force being an increased force with respect to the first force, the second force fixing the position of the further module within the reference plane, releasing the actuator pin and subsequently reactivating the actuator pin and applying a third force by the activator pin for fixing the position of the further module against the datum element or against the datum element and the fixation datum element, and releasing the second force on the further module. The third force applied by the actuator pin being larger than the force necessary to displace the further module with respect to the reference plane. In an embodiment the first force being gravity of the further module.

### BRIEF DESCRIPTION OF THE DRAWINGS:

These and other aspects of the invention are apparent from and will be elucidated with reference to the embodiments described hereinafter.

In the drawings:
Fig. 1 shows an embodiment of the placement system according to the invention,
Fig. 2A shows a first angle component of the angle, and Fig. 2B shows a second angle component of the angle,
Fig. 3 shows an embodiment of the placement system in which the placement system positions a module with respect to a further module,
Fig. 4 shows a plan view of the micromechanical positioning device,
Fig. 5 shows a top view of the micromechanical positioning device,
Fig. 6 schematically shows the first angle component, the second angle component and the applied force when placing the module on top of the further module, and
Fig. 7 shows the at least three resilient support pins.

The figures are purely diagrammatic and not drawn to scale. Particularly for clarity, some dimensions are exaggerated strongly. Similar components in the figures are denoted by the same reference numerals as much as possible.

### DETAILED DESCRIPTION OF THE PREFERRED EMBODIMENTS:

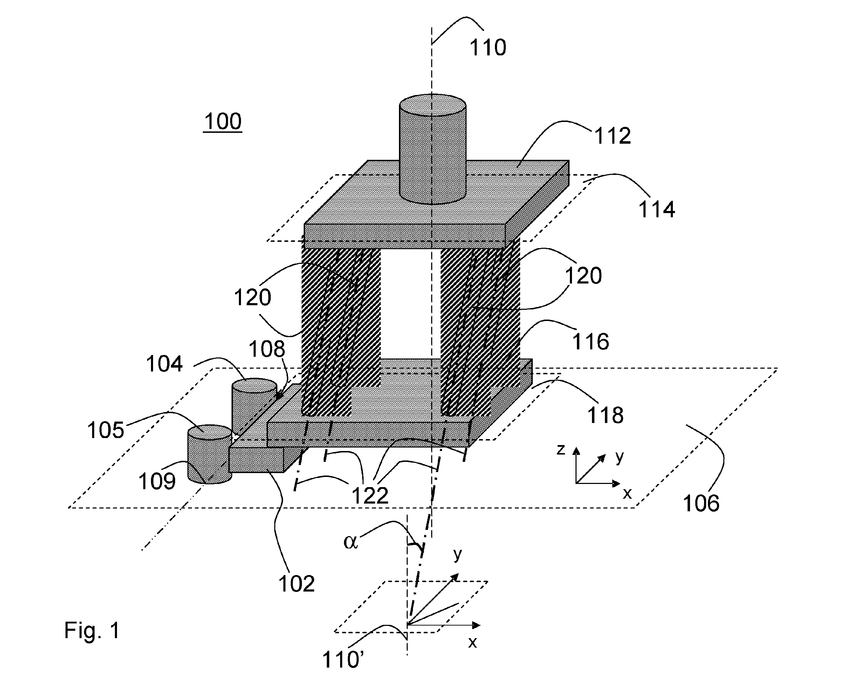

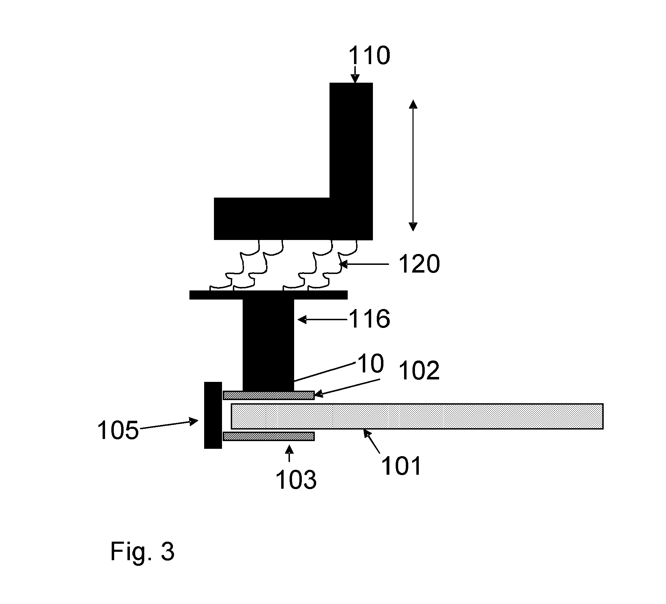

Fig. 1 shows an embodiment of the placement system 100 according to the invention. The placement system 100 comprises a first support member 112 connected to a second support member 116 via substantially identical resilient connectors 120. Each one of the resilient connectors 120 includes a longitudinal axis 122. The resilient connectors 120 are arranged such that the longitudinal axes 122 are all arranged substantially parallel to each other. Furthermore, each one of the resilient connectors is connected to the first support member 112 at the first imaginary plane 114 and is connected to the second support member 116 at the second imaginary plane 118. The first support member 112 is connected to a micromechanical positioning device 80 (see Fig. 3) and the second support member 116 is connected to a module 102. The placement system 100 further comprises a central axis 110 which is oriented substantially perpendicular to a reference plane 106. Figure 1 shows a datum element 104 and a further datum element 105 defining a reference point 108 and a reference line 109 in the reference plane 106. To more clearly show the angle α between the central axis 110 and the longitudinal axis 122, an support axis 110' is defined which is arranged parallel to the central axis 110.

When the module 102 is to be positioned against the datum element 104 or against the datum element 104 and the further datum element 105, the placement system 100 pushes the module 102 against the datum element 104 or against the datum element 104 and the further datum element 105 using a well-defined force substantially parallel to the reference plane 106. Due the resilience of the resilient connectors, the second support member 116 will be displaced with respect to the first support member 112 while substantially maintaining the second imaginary plane 118 parallel to the first imaginary plane 114. The effect of the use of the placement system 100 is that the module 102 can be secured against the reference point 108 or the reference line 109 using a well-defined force while securing the orientation of the module with respect to the reference plane. A further benefit of the use of the placement system 100 is that the resilient connectors 120 decouple vibrations, for example, resulting from the micromechanical positioning device 80 to the module 102. The decoupling of the vibrations increases the accuracy in positioning the module 102 with respect to the reference point 108 or with respect to the reference line 109, thus increasing the accuracy of the micromechanical positioning device 80.

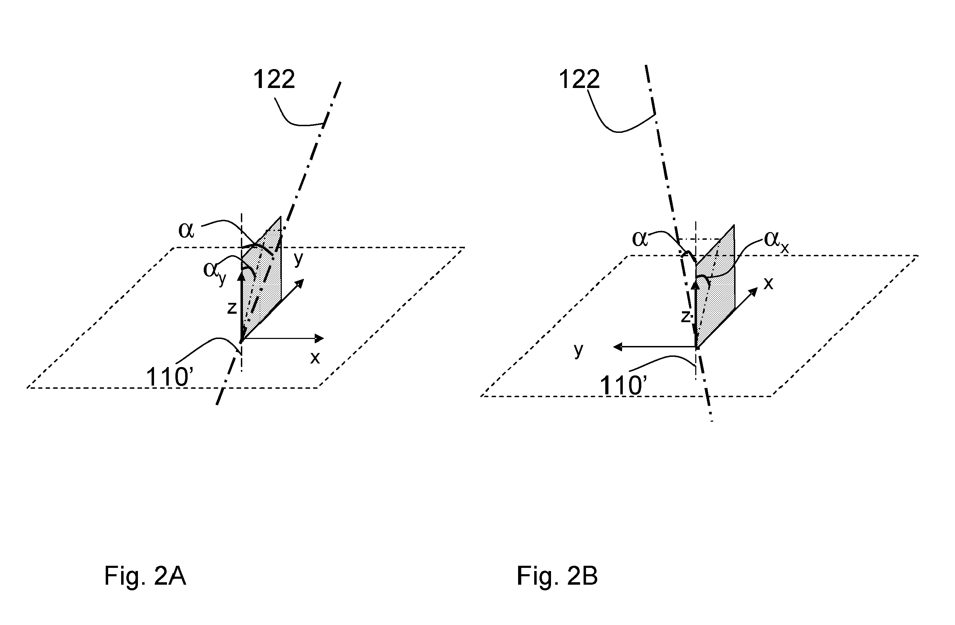

Fig. 2A shows a first angle component αₓ of the angle α. The first angle component αₓ is an angle defined between the support axis 110' and a projection of the longitudinal axis 122 of the resilient element 120 in the plane defined by the vectors y and z. Fig. 2B shows a second angle component α_{y} of the angle α. The second angle component α_{y} is an angle defined between the support axis 110' and a projection of the longitudinal axis 122 of the resilient element 120 in the plane defined by the vectors x and z.

Fig. 3 shows an embodiment of the placement system 100 in which the placement system 100 positions a module 102 with respect to a further module 101, 103. To a first support member 112, such as a free programmable robot, e.g., a SCARA robot (e.g., an Epson robot), a second support member 116 is attached through a series of resilient connectors 120, such as e.g., springs. The second support member 116 may be equipped with a controllable attachment device 10, such as e.g., a suction device, which enables pick and placing of module 102. Aligning in the x-directon of different modules 102 and 103 in a 3D stack of modules is facilitated by a series of datums 104 (not shown) and 105, to which both modules are positioned. In the drawing, module 103 is prefixed to module 101.

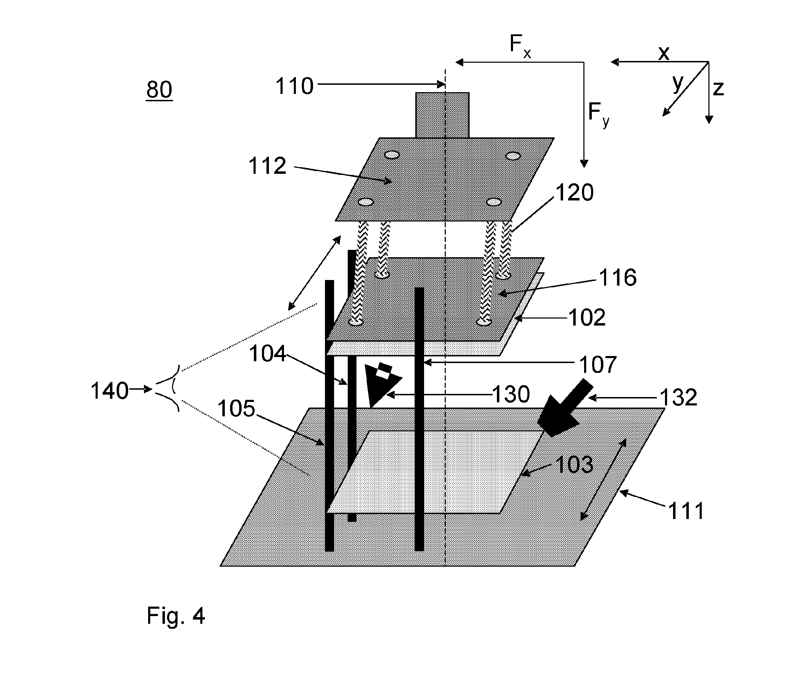

Fig. 4 shows a plan view of the micromechanical positioning device 80. Module 102, which is attached to the second support member 116 using a controllable suction device 10, is aligned to module 103, in the y direction to a fixed datum 107, and aligned in the x direction to a series of sliding datums 104 and 105, which are rigidly connected to a sliding tool tray 111, which may accurately slide in the y direction. An optical monitoring device 140 monitors and controls through a controlling system (not shown) the displacement in the y direction of the sliding tool tray 111.

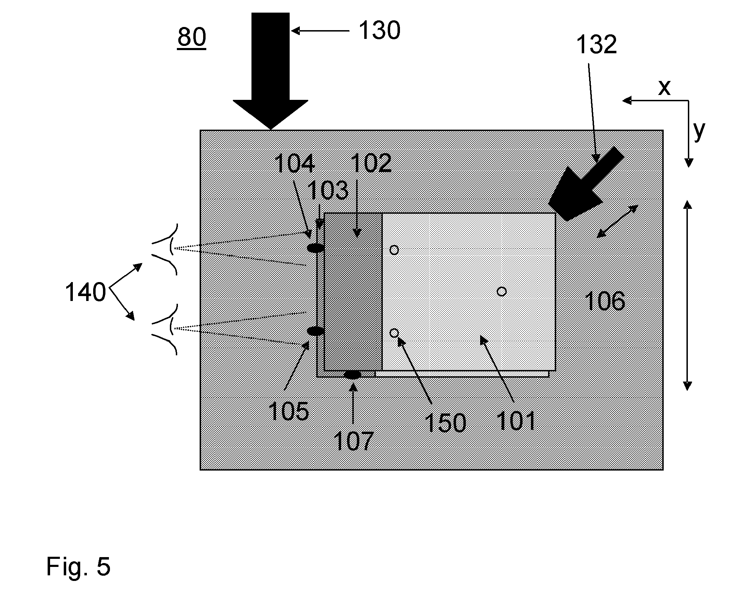

Fig. 5 shows a top view of the micromechanical positioning device 80. A linear actuator 130 is controlled through a control system, which is controlled by optical monitoring devices 140, which monitor the alignment of modules 102 and 103 relative to one another. Both modules are on either side of module 101. Module 102, initially supported by resilient support pins 150, is pressed down and clamped by actuator 132.

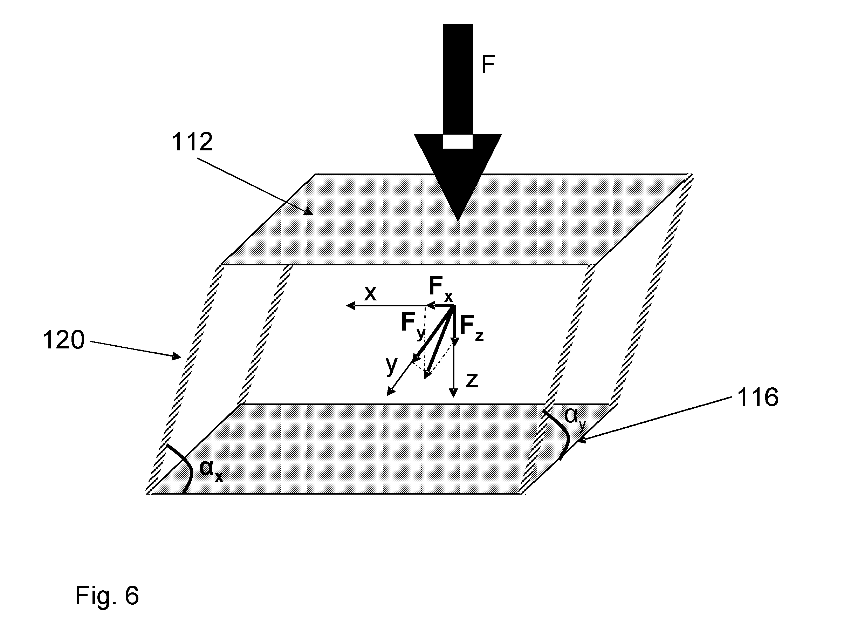

Fig. 6 schematically shows the first angle component αₓ, the second angle component α_{y} and the applied force when placing the module 102 on top of the further module 101, 103. Rhomboidal attachment geometry of resilient connectors 120 connecting the first support member 112 to the second support member 116. When a force F is applied by the first support member, such as a robot arm, to the second support member 116 in the z direction, the angles αₓ and α_{y} determine the inferred forces Fₓ and F_{y} in the x and y directions, respectively.

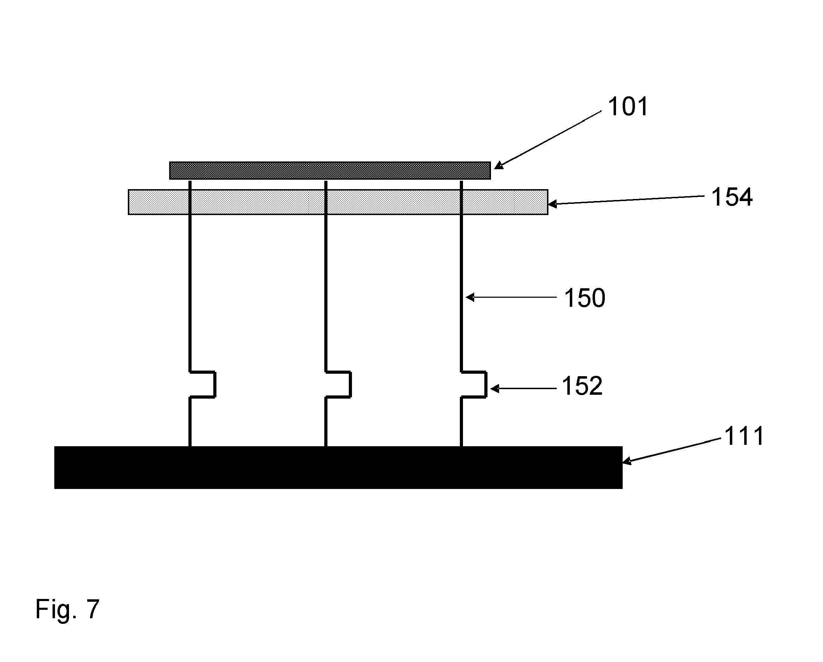

Fig. 7 shows the at least three resilient support pins 150. Resilient support pins 150 for frictionless fixation of modules to datum elements. Three resilient support pins, preferably made of spring steel, are positioned through the support base 154 of the sliding tool tray 111. When a module, e.g., module 101, is placed down on the tool tray 111, it is first supported by the 3 resilient support pins 150. It may subsequently be pressed against datum elements 104 and 105 in a frictionless manner by the actuator 132. Once in position, the module is pressed down using the first support member 112. This is facilitated by the hinges 152 in the resilient support pin 150. The actuator 132 is released and again activated to hold the module in position.

A flexible and modular placement system 100 is connected to a free programmable robot, such as a SCARA robot (e.g., an Epson robot). The placement system 100 is attached to the robot arm by a series of resilient connectors 120. The connectors are placed in such a way that each of the projected front and side planes enclosed between the bottom of the robot arm, the top of the micro-gripper and both connectors form a rhomboidal shape (see Fig.6). The angles αₓ and α_{y} determine the inferred forces Fx and Fy in the x and y directions, respectively, when a force F is applied by the robot arm 1 to the micro-gripper 3 in the z direction. When the angles αₓ and α_{y} are kept small the corresponding forces Fx and Fy are also small. The range for the angles αₓ and α_{y} is 10 degrees +/- 10 degrees, with a preferred value of 3.5 degrees.

This construction enables downward pressing and aligning component 102 relative to substrate 101, 103 and datum elements 104 and 105, with minimal forces and with minimal shearing and impact against these datum pins. Datum pin 107 is fixed and assures the absolute positioning of component 102 in the y direction. Aligning is controlled by a linear actuator 130, such as e.g., a Newport motor with an accuracy of motion of 1 micron. The linear actuator 130 is controlled through a control system which is controlled by optical monitoring devices 140 that monitor the alignment of component 102 and 103 relative to one another in the y direction with a sub-micron accuracy. The linear actuator 130 displaces sliding tool tray 111, to which datum pin 107 is rigidly connected, in the y direction.

The advantages of the present invention are:
Better precision and accuracy of placement and alignment of components using a common robot arm with a rather low accuracy of translational and rotational motion. Low impact and low shearing forces during placement.
Self centering mechanism of the micro-gripper relative to the substrate.
Controllable forces of micro-gripper in x and y direction through number of connectors and orientation of connectors, material choice of connectors, angles between connectors (e.g., αₓ and α_{y}). In order to guarantee a totally parallel surface of the micro-gripper relative to the substrate, compensation mechanisms may be incorporated into the device.

Modes(s) for carrying out the invention: In a first preferred embodiment the robot micro-gripper contains a handling module with detection, such as e.g., a suction device. The handling module that allows the pickup of MST components and foils by applying a vacuum. Alternative handling modules may be provided such as e.g., mechanical grippers, electrostatic, electromagnetic or cryo-grippers. The connectors that connect the robot arm to the micro-gripper are preferably springs and are preferably made of corrosion resistant spring steel. Preferably 4 springs are used which are attached in a rhomboidal geometry (see figure 4).

In a second preferred embodiment two datum pins 105 (only one datum pin is shown in fig. 3) are rigidly connected to a sliding tool tray 111 (not shown in fig.3) which can be accurately translated in the x direction using a high precision linear actuator (not shown in fig. 3). The linear actuator is controlled through a controller system. A further optical monitoring system (not shown in fig.3) provides input information to the controller system. The further optical monitoring system is identical to optical monitoring system 140 but positioned orthogonally with respect to optical monitoring system 140. When the sliding tool tray 111 is translated into the x direction, the datum pins 105 are fixed in position and do not move. The micro-gripper is pressed against these pins while component 102 slides along datum pins 105. By combining first and second preferred embodiments accurate positioning may occur in both x and y directions.

In a third preferred embodiment the micro-gripper is equipped with a dispensing device such as a dispensing needle which is fixed rigidly relative to the gripper. Accurate dispensing patterns of liquids, such as e.g., glue (especially UV-curing glue), may be applied to substrate 6 when liquid is actively or passively flown through the dispensing device. The maximum distance that may be covered by the dispensing head for one position of the robot arm is determined by the maximum distance of movement of the linear actuator before the bottom plane of placement system 100 becomes tilted. This distance is dependent on the attachment geometry and material of the resilient connectors 120. Larger distances may be covered stepwise by readjusting the position of the robot arm. The position of the dispensing device may be protruded relative to the bottom plane of the micro-gripper so as to impose a defined distance between the substrate and the orifice of the dispensing device. The distance may be controlled by shimming. The advantage of this preferred embodiment is that accurate and controlled liquid dispensing is possible over large areas through the combined use of a limited resolution robot arm with a large working area and a high resolution linear actuator motor with a limited working area.

In a fourth preferred embodiment the micro-gripper is equipped with a laser device, such as a diode laser, a CO2 laser, a Nd:YAG laser or an excimer laser. This apparatus enables very accurate laser processing, such as e.g., laser cutting, laser welding and bonding, laser hardening, laser coating, etc., of underlying substrates without distortion angles and the like, which are common when optical laser guiding systems are used. The same advantages apply to this preferred embodiment as for the previously mentioned one.

In a fifth preferred embodiment the datum pin 9 is rigidly connected to a sliding tool tray 13 (not shown in drawings).

The current invention may be applied in micro-mechanical assembly processes in the fields of Microsystem Technology (MST), Micro-Electro-Mechanical Systems (MEMS), micro-fluidics, piezo-electric ceramics micro-systems, lab-on-a-chip manufacturing, jet to manufacture applications, professional ink jetting, fabrication of valves, filters, micro-pumps, drug delivery systems, silicon microphones and cellular phone components, (bio) sensors and actuators, LEDS (for UV curing, bright LEDS as alternative for conventional lighting), polymer electronics (OLEDS, printed electronics, flexible displays, photovoltaic (solar cells),smart textiles), lens stacking applications, the assembly of CCD chips for imaging and laser-guiding devices.

Chip manufacturing methods in the semiconductor and electronics industry which are based on complementary metal oxide semiconductor (CMOS) technology and first level packaging by soldering (e.g., dye and wire bonding) are considered as conventional technology nowadays. Restriction of certain hazardous substances (RoHS) and the Waste Electrical and Electronic Equipment (WEEE) directives will restrict the use of this technology. Alternative manufacturing and second level packaging methods provide new innovative solutions and anticipate on these developments. Precise and accurate integration & packaging of components relative to one-another within a 3D environment becomes more and more a functional requirement in the assembly process of micro-devices. More control with respect to translational and rotational alignment is generally required. Integrated laser scanning devices (profilometers) and vision-based systems are often employed to gain control in micro-mechanical assembly processes. Especially 3D stacking is particularly under development because of market-driven requirements that impose restrictions on size and volume in which microsystems are embedded. Miniaturization is basically driven by economic forces (cheaper, faster, less material used etc.), but also by quality factors which are related to product performance. Functional requirements that determine product performance are often directly related to preciseness and accuracy of placement, alignment and assembly of micro-components. A conventional means of placing components in such an environment is to use a pick-and-place robot such as eg., a free programmable SCARA robot, such as e.g., an Epson robot. Using such a method has some inherent drawbacks. First, the accuracy of placement by such a robot system is rather limited to about 10-20 microns. Second, because of a direct rigid connection between the component and the robot gripper transfer and alignment errors in the robot motion have a direct impact on the accuracy of placement. Moreover, the risk of damaging and shearing fragile and brittle components, such as eg., piezo ceramics, is rather high especially if a force is applied to press the component in it's destination position. The current invention provides a convenient and flexible method and apparatus for a more precise and accurate 3D translational alignment and placement of Microsystems Technology (MST) components in micro-mechanical assembly processes without the afore mentioned drawbacks and restrictions.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements. In the device claim enumerating several means, several of these means may be embodied by one and the same item of hardware. The mere fact that certain measures are recited in mutually different dependent claims does not indicate that a combination of these measures cannot be used to advantage.

## Claims

1. A placement system (100) in a micromechanical positioning device (80) for positioning a module (102) with respect to a datum element (104) defining a reference position (108) in a reference plane (106) for the module (102), the placement system (100) comprising:
a central axis (110) substantially perpendicular to the reference plane (106),
a first support member (112) including a first imaginary plane (114) substantially parallel to the reference plane (106), the first support member (112) arranged for connecting to the micromechanical positioning device (80),
a second support member (116) including a second imaginary plane (118) substantially parallel to the reference plane (106), the second support member (116) arranged for connecting to the module (102),
at least three substantially identical resilient connectors (120) arranged for resiliently connecting the first support member (112) at the first imaginary plane (114) to the second support member (116) at the second imaginary plane (118), each resilient connector (120) having a longitudinal axis (122), the longitudinal axis (122) of each resilient connector (120) being substantially parallel to each other and defining an angle (α) with regard to the central axis (110).

2. Placement system (100) as claimed in claim 1, wherein first depressions are provided in the first support member (112) facing the second support member (116) and second depressions are provided in the second support member (116) facing the first support member (112), said first and second depressions accommodating end portions of the respective resilient connectors (120), each one of the first and second depressions having a depression central axis substantially parallel to the longitudinal axis (122) of each of the resilient connectors (120).

3. Placement system (100) as claimed in claim 1 or 2, wherein the placement system (100) comprises four substantially identical resilient connectors (120).

4. Placement system (100) as claimed in claim 1 or 2, wherein the angle (α) is smaller than 45 degrees, and preferably between 1 and 10 degrees.

5. Placement system (100) as claimed in claim 1 or 2, wherein the angle (α) between the longitudinal axis (122) and the central axis (110) comprises a first angle component (αₓ) in a first direction (x) parallel to the reference plane (106) and comprises a second angle component (α_{y}) in a second direction (y) parallel to the reference plane (106) and perpendicular to the first direction (x).

6. Placement system (100) as claimed in any of the previous claims, wherein the module (102) comprises a micro-gripper, a dispensing device, a mirror, a mirco-torch, or a laser device.

7. Micromechanical positioning device (80) comprising a robot arm comprising the placement system (100) of one of the preceding claims, and comprising the datum element (104) defining a reference position (108) in the reference plane (106), the micromechanical positioning device (80) further comprising a translation means (130) for either translating the module (102) with respect to a further module (101, 103), or for translating the further module (101, 103) with respect to the module (102) for aligning the module (102) and the further module (101, 103) with respect to each other.

8. Micromechanical positioning device (80) as claimed in claim 7, the micromechanical positioning device (80) further comprising a further datum element (105), the datum element (104) and the further datum element (105) defining a reference line (109) coinciding with the reference position (108), wherein the translation means (130), when translating,
either translates the module (102) with respect to the further module (101, 103), the module (102) sliding along the datum element (104) and the further datum element (105),
or translates the further module (101, 103) with respect to the module (102), the further module (101, 103) sliding along the datum element (104) and the further datum element (105).

9. Micromechanical positioning device (80) as claimed in claim 7 or 8, the micromechanical positioning device (80) further comprising a fixation datum element (107) for either fixing a predetermined position of the module (102) when the further module (101, 103) is translated or for fixing a predetermined position of the further module (101, 103) when the module (102) is translated.

10. Micromechanical positioning device (80) as claimed in claim 7, 8 or 9, wherein the micromechanical positioning device (80) comprises at least three resilient support pins (150) for supporting the further module (101, 103) and comprises an actuator pin (132) for fixing a reference position of the further module (101, 103) against the datum element (104), or against the datum element (104) and the fixation datum element (107), the resilience of the at least three resilient support pins (150) enabling a displacement of the further module (101, 103) with respect to the reference plane (106) while omitting a need for sliding the further module (101, 103) over the at least three resilient support pins (150).

11. A placement method for placing the further module (101, 103) in the micromechanical positioning device (80) as claimed in claim 10, the placement method comprising a step of:
placing the further module (101, 103) on the at least three resilient support pins (150),
applying a first force on the further module (101, 103) in a direction substantially perpendicular to the reference plane (106) pressing the further module (101, 103) against the at least three resilient support pins (150), the first force being chosen to allow the further module (101, 103) to be displaced with respect to the reference plane (106) while omitting the need for sliding the further module (101, 103) over the at least three resilient support pins (150),
activating the actuator pin (132) for displacing the further module (101, 103) against the datum element (104), or against the datum element (104) and the fixation datum element (107),
replacing the first force by a second force on the further module (101, 103), the second force being an increased force with respect to the first force, the second force fixing the position of the further module (101, 103) within the reference plane (106),
releasing the actuator pin (132) and subsequently reactivating the actuator pin (132) and applying a third force by the activator pin for fixing the position of the further module (101, 103) against the datum element (104) or against the datum element (104) and the fixation datum element (107), and releasing the second force on the further module (101, 103).
